# EUROPEAN PATENT SPECIFICATION

(11) **EP 0 505 076 B1**
(45) Date of publication and mention of the grant of the patent: **05.07.1995**
(21) Application number: 92302034.1
(22) Date of filing: 10.03.1992
(51) Int. Cl.: H05K 3/30

(54) **Pressing apparatus and method**
Andrückvorrichtung und Verfahren
Appareil et procédé pour presser

(30) Priority: 22.03.1991 US 673906
(43) Date of publication of application: 23.09.1992
(73) Proprietor: International Business Machines Corporation, Armonk, N.Y. 10504 (US)
(72) Inventor: Kroeker, Elmer Leroy Bob, Round Rock, Texas 78781 (US); Kroeker, Tony Ray, Georgetown, Texas 78628 (US); Sage, Robert Norman, Allentown, PA 18103 (US)
(74) Representative: Burt, Roger James, Dr.

(56) References cited:
- AT-B- 320 056
- DE-A- 1 915 159
- DE-A- 2 502 723
- US-A- 4 463 310
- US-A- 4 627 157
- US-A- 4 733 459
- US-A- 4 819 326
- US-A- 4 827 607

## Description

Circuit board assembly personnel are required manually to force each component into an engaged relation with a printed circuit board PCB. The types of connection used by these components often include those of the interference type. That is, a post or the like is forced into a hole within the PCB having a diameter smaller than that of the post. A great deal of force is required to complete this type of connection. Further, if the required force is not applied uniformly from a vertical direction, the pins will become bent and deformed and not enter the vias contained within the PCB. Thus, a need exists for a means of simultaneously pressing at least one interference type electrical component on to a PCB. Additionally, the capability is needed immediately to determine if each pin on all the components being placed on to the PCB have been inserted through the vias a sufficient distance to ensure proper affixation.

A conventional system is described by US-A-4,627,157 wherein components are individually connected (crimped) and tested as they are successively placed on to a circuit board. US-A-4,733,459 describes inserting, but not testing, electronic parts into a PCB, by an apparatus including a positioning mechanism and pivotable hand portion. US-A-4,463,310 shows testing for the presence of components on a previously assembled circuit board, but makes no provision for simultaneously placing and concurrently testing components during a single operation.

It can be seen that a need exists for an apparatus and method of simultaneously placing a plurality of individually configured electrical components, having interference connections, on to a PCB. Further, a means of immediately verifying, to an operator, that proper placement of the component on to the PCB has occurred would be desirable.

The present invention seeks to provide a tool which allows simultaneous placement of electrical components on to a printed circuit board. Further, testing for the proper placement of these components on the PCB is performed so that an operator can immediately replace any components having pins which are bent, deformed, or the like.

According to the invention, there is now provided apparatus for pressing at least one electrical component on to a circuit board, the electrical component comprising a plurality of electrically conductive pins to be inserted into corresponding vias contained within the circuit board, the apparatus comprising means for applying uniform pressure to the component in a substantially vertical direction, characterised in that the apparatus comprises means for verifying the proper placement of the component on the circuit board, the verifying means comprises means for providing an indication that a pin is absent from the corresponding via, the indication providing means including an electrical power source and circuit means for providing an electrically conductive path including the electrical power source when a pin is absent from the corresponding via, the circuit means comprising an electrical test probe for each pin, disposed within an electrically insulating body portion, and having an electrically conductive end portion and electrical contact means disposed on an end of the test probe opposite the end portion and biased into contact with an annular shoulder provided at a hole in an electrical conductive layer disposed between the probe and a circuit board position, the annular shoulder having a diameter less than the contact means, each probe being alignable with a via on a side of the circuit board position opposite the component, the electrical contact means being depressible by a pin extending through a via and into the hole to break contact with the overlapping part.

Viewing the present invention from another aspect, there is now provided a method for pressing at least one electrical component on to a circuit board the component having a plurality of electrically conductive pins to be inserted into corresponding vias contained within the circuit board, comprising the steps of applying uniform pressure to the component in a substantially vertical direction, and verifying the proper placement of the component on the circuit board, the step of verifying comprising providing, using circuit means, an electrically conductive path between an indicating means and an electrical power source when a pin is absent from the corresponding via, the circuit means including an electrical test probe for each pin, disposed within an electrically insulating body portion, and having an electrically conductive end portion and electrical contact means disposed on an end of the test probe opposite the end portion and biased into contact with an annular shoulder provided at a hole in an electrical conductive layer disposed between the probe and a circuit board position, the annular shoulder having a diameter less than the contact means, each probe being aligned with a via on a side of the circuit board position opposite the component, the electrical contact means being depressible by a pin extending through a via and into the hole to break contact with the annular shoulder.

In an embodiment of the invention, a press is provided having movable platens which receive a product specific assembly that is used in the manufacture of a particular type of PCB. For example, a PCB may require a number of electrical components, such as card connectors, or the like, to be affixed thereto. This product specific assembly includes a top plate and pressure bar, which contacts the component being pressed into place, and a spring intermediate therebetween. A bottom plate is provided and includes a test assembly block attached thereto. The test block serves to support the PCB receiving the electrical component and verifies the presence of each pin of the component in the respective via. An electrical contact is placed adjacent the vias in the PCB which are to receive the pins. If the pin is not present, or does not extend through the via a sufficient distance, then an indication of a faulty connection is provided to the operator.

The product specific assembly is placed between the platens of the press such that closing the platens will apply a uniform force to the electrical component and press it into place on the PCB. Simultaneously, an indication of proper pin placement is provided to the operator.

The scope of the invention is defined by the appended claims; and how it may be carried into effect is hereinafter particularly described with reference to the accompanying drawings, in which:-
Figure 1 is a schematic diagram showing a side elevation of the press apparatus according to the present invention;
Figure 2 is a front elevation of the press apparatus of Figure 1;
Figure 3 is a back elevation of the top portion of the press apparatus of Figure 2;
Figure 4 is a perspective view of a representative electrical component and a printed circuit board to be attached by the press apparatus according to the present invention;
Figure 5 is a broken side view, partly in section, of a product specific insert used to mount electrical components on a printed circuit board;
Figure 6 is a schematic cross-section, to an enlarged scale, of part of Figure 5;
Figure 7 is an elevational view of a set of product specific plates for use in the product specific insert of Figure 5; and
Figure 8 is a plan view along the line 8-8 of Figure 7.

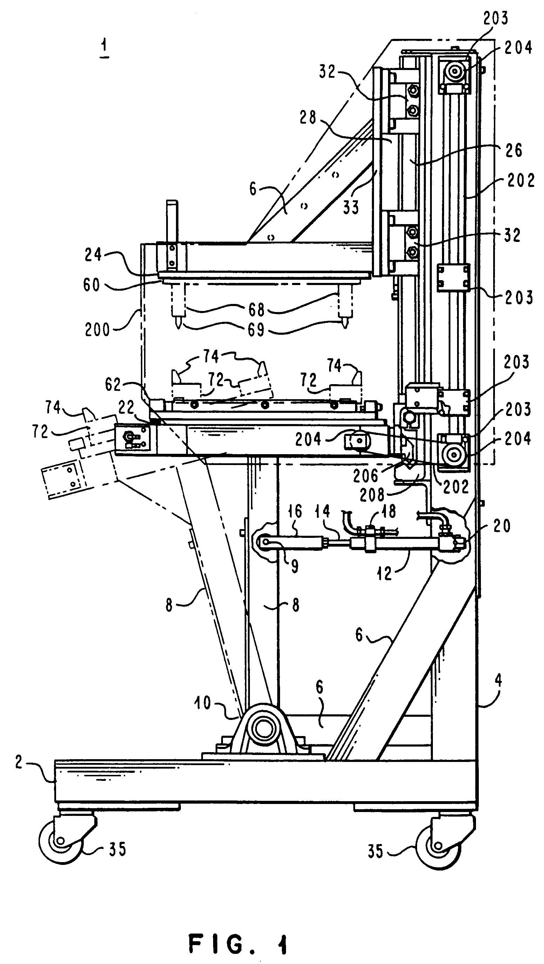

A press apparatus 1 (Figure 1) according to the present invention has a base 2 supporting the weight of the press and mounted upon rollers 35 which provide for mobility of the press apparatus 1. A support 4 rises vertically from one end of the base 2 and is supported by various braces 6. A plate support 8 supports a lower base platen 22 and is pivotally attached to the base 2 through a connector 10 which may be a pin and hole, ball bearing arrangement, or the like. The support 8 is in a substantially normal operating position during the actual press operation, but can be tilted outwardly to accommodate the press operator, as shown in chain lines. The outward tilting of support 8 and platen 22 is implemented by a fluid pressure system including a cylinder 12, which may be hydraulic, pneumatic, or the like, a ram 14 and control valves 18 and 20 which provide fluid pressure that control the movement of ram 14 within cylinder 12. Ram 14 is connected to support 8 by a yoke 16 and pin 9. Other connection means may be used. Fluid pressure applied to valve 20 causes ram 14 to extend outwardly thereby tilting lower platen 22 towards all operator. Conversely, fluid pressure applied to valve 18 causes ram 14 to retract and return support 8 to the substantially vertical position and platen 22 to a substantially horizontal position.

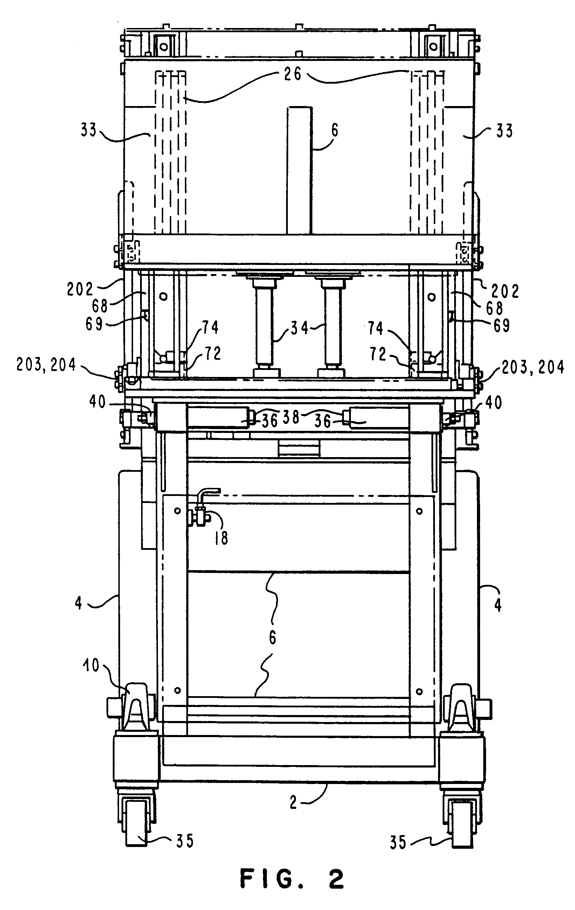

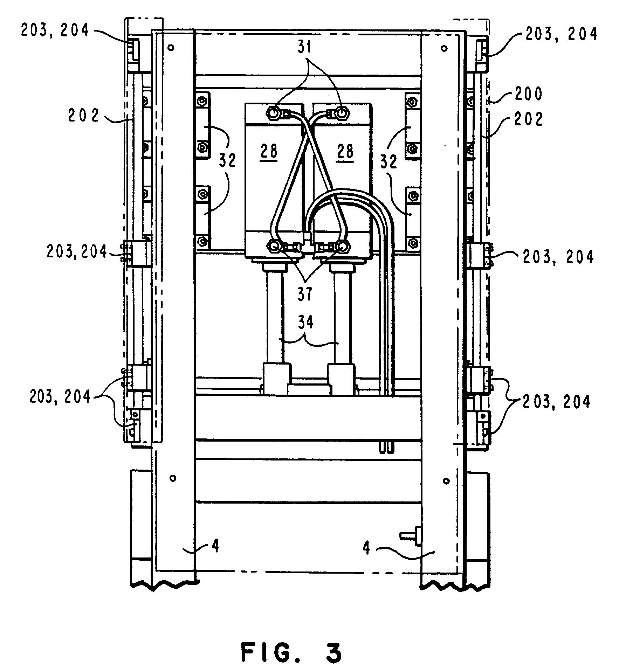

A top platen 24 to provide the downward force which is required to press an interference type electrical component, or the like into a printed circuit board is supported horizontally by a brace 6 from a vertical support plate 33. The plate 33 as connector slides 32 engaged on vertical tracks 26 (Figure 2) mounted substantially adjacent support 4 and parallel thereto. A fluid pressure system provides the vertical movement of platen 24 with respect to bottom platen 22. Cylinders 28 (Figure 3) are mounted on the back of tie plate 33. The cylinders 28 have rams 34 rigidly fixed to the base of the press apparatus 1 through the support 4, so that upon actuation of hydraulic cylinders 28, top platen 24 is vertically displaced in relation to bottom platen 22. Valves 31 and 37 control the flow of fluid under pressure to and from the cylinders 28. Upon application of fluid pressure to valves 31, cylinders 28 are vertically raised due to the rigid attachment of ram 34 to support 4 and thus the top platen 24 is raised. When fluid pressure is applied to valves 37, cylinders 28 are drawn in a downward vertical direction to lower top platen 24 with respect to bottom platen 22. Thus the preferred embodiment of press apparatus according to the present invention, employs fluid pressure systems to raise and lower the top platen 24 with respect to the lower platen 22, and to tilt the lower platen 24 outwardly.

Handles 36 (Figure 2) allow an operator easily to operate the fluid pressure systems used to control the outward tilting lower platen 22 and vertically moving upper platen 24 (Figure 1). Switches 38 are provided on the distal ends of handles 36 and can be easily engaged by application of pressure from an operator's thumb. The application of pressure upon switches 38 activates fluid pressure valves 40, located at the opposite ends of handles 36. In this way, fluid pressure is supplied to valves 18 and 20 thereby controlling tilting of lower platen 22, and to valves 31 and 37 controlling vertical movement of top platen 24. The fluid pressure circuit is preferably designed so that application of pressure to both switches 38 is required to allow vertical movement of top plate 24. This adds a safety feature, because both hands of the operator must be used to initiate movement of platen 24 and therefore they cannot be placed inadvertently in the path of platen 24 as it is lowered. A transparent cover 200 (Figure 1) made of plexiglass, or the like is disposed around the upper part of the press and between the operator and the space under the top platen 24. The cover 200 is opened upon activation by a series of interconnected belts 202, brackets 203 and pulleys 204, which, are connected to a drive means (not shown) such as a motor or the like. Locking means 206 is also provided which is in releasable communication with a bracket 208. Thus, lower platen 22 cannot be tilted outwardly until the locking means 206 is released by the operator.

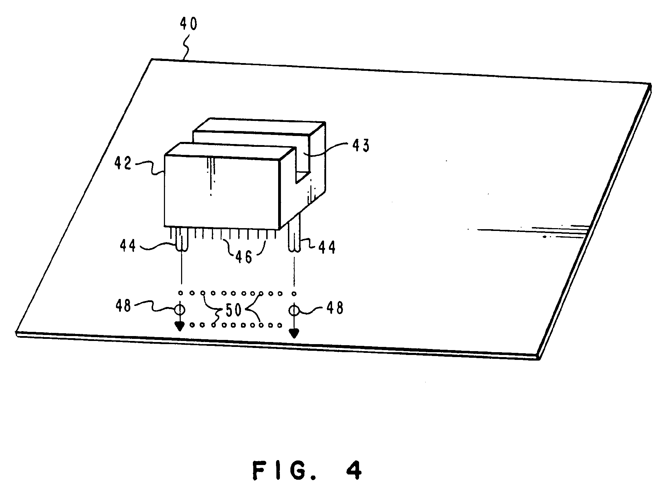

The press apparatus is used to mount electrical components, such as component 42 (Figure 4), on a circuit board, such as printed circuit board (PCB) 40. The component 42 is an interference type electrical component and is a connector having a groove 43 to receive an adapter card or the like, and to provide a connection to the PCB 40. Connector component 42 includes alignment posts 44 designed to mate with corresponding holes 48 formed through PCB 40. As component 42 is of the interference type, the outside diameter of each post 44 is greater than the diameter of each hole 48, so that a great deal of force is required to seat connector 42 onto PCB 40. Connector pins 46 exposed linearly along each side of connector 42, mate with vias 50 formed in PCB 40, so that electrical connections are made between PCB 40, connector 42 and the adapter card, or the like (not shown) seated in groove 43. Due to the amount of force required to seat connector 42 onto PCB 40, a very small misalignment of pins 46 with respect to vias 50 will result in pins 46 being bent or deformed so that full electrical contact between connector 42 and PCB 40 is not achieved.

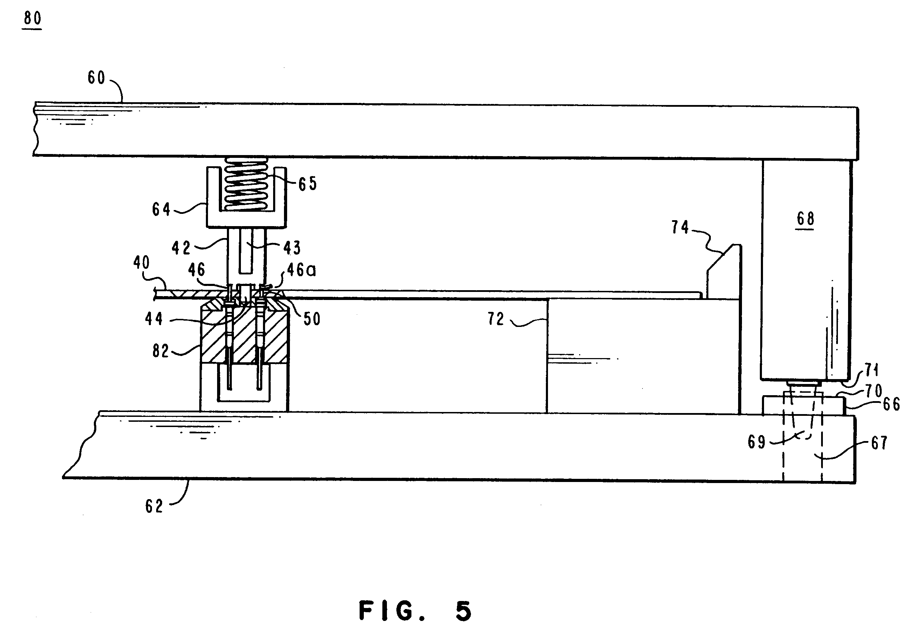

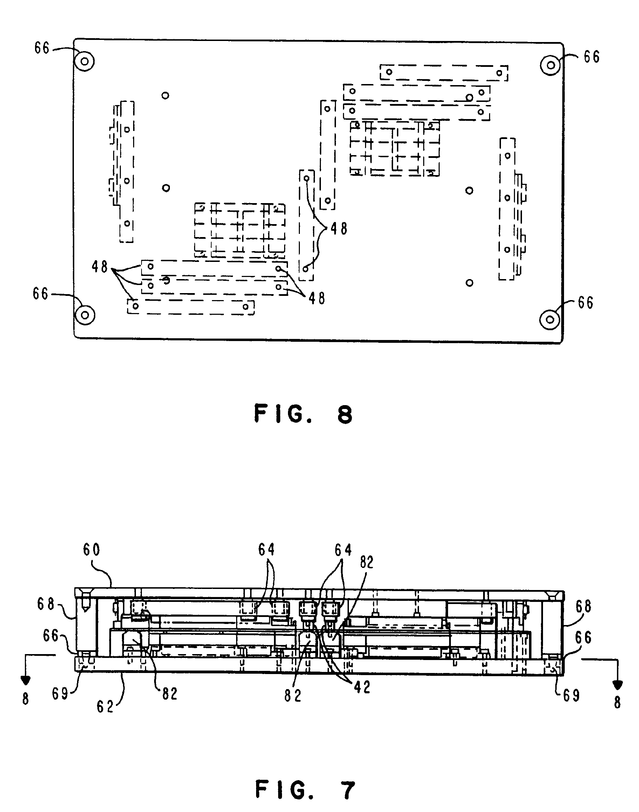

A product specific insert 80 (Figure 5) is used in the press apparatus. The insert 80 includes a top plate 60 and a bottom plate 62 releasably secured to top platen 24 and bottom platen 22, respectively. Attached to top plate 60 are alignment posts 68 or the like having tapered ends 69. One end of at least one spring 65 is secured to top plate 60 by conventional means such as welding, or the like. The opposite end of spring 65 is secured to a pressure plate 64 which abuts the electrical component 42 to be pressed into circuit board 40. Although only a single spring 65 and pressure plate 64 are shown, it will be understood that as many such spring and plate assemblies are attached to top plate 60 as to enable several components 42 (Figures 7 and 8) to be pressed simultaneously into PCB 40. Spring 65 is used to ensure that a constant uniform downward force is applied to component 42. Each of a plurality of springs 65 may have a different tension to correspond to the particular component 42 to be pressed into PCB 40. Additionally, springs 65 of different lengths can be provided, so that components 42 having different heights can be pressed simultaneously into the PCB 40.

Circuit board supports 72 are disposed in a substantially rectangular arrangement on bottom plate 62 to correspond with the four corners of PCB 40. Guides 74 are rigidly secured to supports 72 and ensure that PCB 40 is properly aligned by the operator during insertion of the board during the mounting operation.

Attached to bottom plate 62 is a test block 82 for each particular component 42 to be pressed into the PCB 40.

A travel stop 66 is mounted on bottom plate 62 under each alignment post 68 to receive the tapered end 69 into a cylindrical cavity 67 thereby ensuring that top plate 60 and bottom plate 62 maintain vertical alignment. Additionally, stop 66 provides a shoulder 70 which abuts a shoulder 71 of alignment means 68 when the proper downward vertical distance of top plate 60 is achieved. In this way, over-travel of top plate 60 relative to bottom plate 62, is prevented and damage to components 42 is avoided. As guides 74 maintain alignment of PCB 40 with respect to bottom plate 62 and test blocks 82, and alignment posts 58 and stops 66 maintain alignment of bottom plate 62 with respect to top plate 61, then pressure plate 64 will be aligned with component 42. If, for some reason, a pin 46 of the component 42 fails to enter its via 50 in the PCB 40, it may as a bent pin 46A.

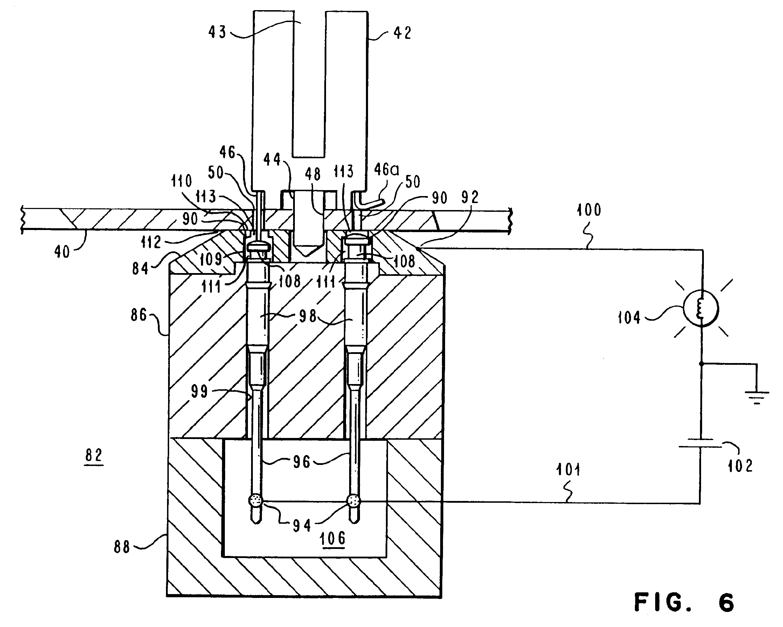

To test for the absence of such bent pins, testing for the presence of pins 46 within vias 50 is effected concurrently with the manufacturing process of placing components 42 on PCB 40. After an electrical component 42 (Figure 6) has been pressed on to PCB 40 so that alignment post 44 is inserted into hole 48 and electrical connection pin 46 extends into via 50, one of the pins 46A has been bent during the placement process and does not extend into via 50.

Test block 82 includes a lower body portion 88 constructed of an electrically insulating material such as polymer, epoxy, plastics material or the like. Body portion 88 has a cavity 106 located substantially in the centre. An upper body portion 86, also of an electrical insulating material, is disposed in abutting relation with lower portion 88 so that cavity 106 forms a hollowed out interior area within test block 82. Lower body portion 88 is rigidly affixed to bottom plate 62 by conventional means, such as glueing, bonding or the like. Top portion 86 is used to support test probes 98 each of which is insertable into a substantially cylindrical hole 99 which extends through the height of upper portion 86. An electrical contact head 108 is slidably disposed within each test probe 98 and will contact a pin 46 when the pin is properly inserted through via 50. Each test probe 98 includes biasing means (not shown) such as a spring or the like which will maintain its contact 108 in an upward position. An electrically conductive top layer 84 is affixed by lamination, or the like to top portion 86 and includes a surface 112 which is in abutting relation with PCB 40 when the board is placed within product specific insert 80. Surface 112 provides support for PCB 40 during the time when component 42 is being pressed into place, in order to avoid deformation of PCB 40.

Top layer 84 includes a first cylindrical hole 111, defined by outer wall 109 which is sized to allow electrical contacts 108 to be maintained therein. A second cylindrical hole 113, defined by outer wall 110, is provided within conductive layer 84 and in coaxial communication with the first hole 111. The second hole 113 is of a smaller diameter than the first hole 111 so that an annular shoulder 90 is formed at the point of communication therebetween. The diameter of the second hole 113 is less than the diameter of electrical contact 108 so that, when contact 108 is upwardly biased, an electrically conductive path is maintained from contact 108 through annular shoulder 90. Conversely, when pin 46 is present in via 50 and extends downwardly into the holes 113 and 111, electrical contact 108 is depressed into the hole 111 so that an electrically conductive path is not provided between annular shoulder 90 and contact 108. An electrical connection 92 is made between layer 84 and a wire 100. Each probe 98 has an electrically conductive lower portions 96 which extends into cavity 106 of lower body portion 88. Electrical connections 94 connect the lower portions 96 of probes 98 with a wire 101. Electrical connections 92 and 94 are made with conventional means such as soldering, mechanical connectors or the like. Wires 100 and 101 are then connected to an indicator 104 and a power source 102, respectively. Indicator 104 may include a light, buzzer or the like, while a battery may he used for power source 102.

When a pin 46A is bent and does not push its contact 108 down, an electrical circuit is made from battery 102 through wire 101, probe end 96, probe 98, electrical contact 108, annular shoulder 90, layer 84, wire 100 to indicator 104 and the absence of a pin 46 within via 50 is sensed. Under normal conditions when all pins are present within vias 50 and extend downwardly a sufficient distance, the electrical circuit remains open because an electrical path is not made between any contact 108 and its corresponding annular shoulder 90. Under these conditions, no indication of absent pins 46 is provided to the operator, thereby verifying the proper placement of component 42 on to PCB 40. It should be noted that probes 98 are connected in parallel, so that the absence of a single pin will indicate to the operator that a defect has occurred and immediate replacement of component 42 can be effected.

This test also determines whether component 42 is in fact seated properly on PCB 40. If component 42 is not directly seated upon PCB 40 pins 46 will not extend through vias 50 and into the holes 113 and 111, a sufficient distance to bias contact 108 downward, thereby maintaining an open condition in the electrical circuit. Thus not only is the absence of a pin 46 detected but also the insufficient extension of a pin 46 through via 50 is indicated. This is extremely important as the pins 46 must extend past the lower face of PCB 40 a sufficient distance to provide for proper connection, such as by wave soldering or the like. By varying the length of wall 110 between PCB 40 and the annular shoulder 90, the distance required for pin 46 to extend through via 50, and past the lower portion of PCB 40, to bias contact 108 downwardly, may be varied. In this manner, the sensitivity of test block 82 can be altered so that pins 46 of varying lengths can be accommodated.

When several different components 42 are to be mounted on a PCB 40, several pressure plates 64 (Figure 7) are attached to top plate 60, and bottom plate 62 has several test blocks 82 attached thereto. A representative pattern of the placement of electrical components 42 (Figure 8) on to PCB 40, is but one example of a virtually unlimited number of patterns of components 42 to be used in the production and population of printed circuit boards 40.

The described apparatus enables uniform pressure to be applied to a component or components to be pressed on to a circuit board and the proper placement of the component or components to be verified.

The present invention relates generally to the assembly of electronic components on to a printed circuit board (PCB). Simultaneous to the components being pressed on to the PCB, the present invention performs a test to ensure that all the contact points (pins) of the electrical component are present in their respective holes (vias) in the PCB. Further, the present invention determines whether the pins are fully extended through the vias in order to allow for subsequent permanent affixation of the electrical components to the PCB by soldering, or the like.

## Claims

1. Apparatus for pressing at least one electrical component (42) on to a circuit board (40), the electrical component (42) comprising a plurality of electrically conductive pins (46) to be inserted into corresponding vias (50) contained within the circuit board (40), the apparatus comprising means (80) for applying uniform pressure to the component in a substantially vertical direction, characterised in that the apparatus comprises means (82) for verifying the proper placement of the component (42) on the circuit board (40), the verifying means (82) comprising means for providing an indication that a pin is absent from the corresponding via, the indication providing means including an electrical power source and circuit means for providing an electrically conductive path including the electrical power source when a pin is absent from the corresponding via, the circuit means comprising an electrical test probe (98) for each pin, disposed within an electrically insulating body portion (86), and having an electrically conductive end portion (96) and electrical contact means (108) disposed on an end of the test probe opposite the end portion and biased into contact with an annular shoulder (90) provided at a hole (113) in an electrical conductive layer (84) disposed between the probe and a circuit board position, the annular shoulder (90) having a diameter less than the contact means (108), each probe (98) being alignable with a via on a side of the circuit board position opposite the component, the electrical contact means (108) being depressible by a pin (46) extending through a via (50) and into the hole (113) to break contact with the overlapping part (90).

2. Apparatus according to claim 1, including base plate means for receiving the circuit board, and top plate means for providing downward application of pressure to the component.

3. Apparatus according to claim 2, wherein the base plate means includes first alignment means for aligning the circuit board with respect to the base plate means, and means for supporting the circuit board during pressure application.

4. Apparatus according to claim 3, wherein the top plate means includes second alignment means for providing vertical alignment of the top plate means with the base plate means, and spring means for ensuring the uniform application of pressure to the component.

5. Apparatus according to claim 2, 3 or 4 wherein the pressure applying means is arranged to apply pressure between the top plate means and the base plate means.

6. A method for pressing at least one electrical component on to a circuit board the component having a plurality of electrically conductive pins to be inserted into corresponding vias contained within the circuit board, comprising the steps of applying uniform pressure to the component in a substantially vertical direction, and verifying the proper placement of the component on the circuit board, the step of verifying comprising providing, using circuit means, an electrically conductive path between an indicating means and an electrical power source when a pin is absent from the corresponding via, the circuit means including an electrical test probe (98) for each pin, disposed within an electrically insulating body portion (86), and having an electrically conductive end portion (96) and electrical contact means (108) disposed on an end of the test probe opposite the end portion and biased into contact with an annular shoulder (90) provided at a hole (113) in an electrical conductive layer (84) disposed between the probe and a circuit board position, the annular shoulder (90) having a diameter less than the contact means (108), each probe (98) being aligned with a via on a side of the circuit board position opposite the component, the electrical contact means (108) being depressible by a pin (46) extending through a via (50) and into the hole (113) to break contact with the annular shoulder (90).

7. A method according to claim 6, wherein pressure is applied downwardly upon the component.

## Patentansprüche

1. Eine Vorrichtung zum Andrücken mindestens einer elektrischen Komponente (42) auf eine Leiterplatte (40), wobei die elektrische Komponente (42) eine Mehrzahl elektrisch leitender Stifte (46) umfaßt, die in entsprechende auf der Leiterplatte (40) enthaltene Löcher (50) eingesteckt werden, wobei die Vorrichtung ein Mittel (80) für das Anlegen eines gleichmäßigen Drucks auf die Komponente in im wesentlichen vertikaler Richtung umfaßt, dadurch charakterisiert, daß die Vorrichtung ein Mittel (82) zur Überprüfung des richtigen Anbringens der Komponente (42) auf der Leiterplatte (40) umfaßt, daß das Überprüfungsmittel (82) ein Mittel zur Bereitstellung einer Anzeige darüber umfaßt, ob ein Stift in einem entsprechenden Loch fehlt, wobei die Anzeige ein Mittel einschließlich einer elektrischen Stromquelle und eines Stromkreises zur Bereitstellung eines elektrisch leitenden Pfades mit der elektrischen Stromquelle umfaßt, wenn ein Stift in einem entsprechenden Loch fehlt, wobei das Schaltungsmittel einen elektrischen Testfühler (98) für jeden der Stifte umfaßt, die in einem elektrisch isolierten Gehäuseteil (86) angeordnet sind und einen elektrisch leitenden Endteil (96) und ein elektrisches Kontaktmittel (108) besitzen und an einem Ende des Testfühlers gegenüber dem Endteil angebracht sind und in Kontakt liegen mit einer ringförmigen Schulter (90), die sich in einem Loch (113) in einer elektrisch leitenden Schicht (84) zwischen dem Fühler und einer Leiterplattenposition befindet, wobei die ringförmige Schulter (90) einen kleineren Durchmesser aufweist als das Kontaktmittel (108), wobei jeder Fühler (98) ausrichtbar ist mit einem Loch auf der Seite der Leiterplattenposition gegenüber der Komponente, wobei das elektrische Kontaktmittel (108) von einem Stift (46), der durch die Öffnung (50) in ein Loch (113) ragt, nach unten gedrückt werden kann, um den Kontakt mit dem überlappenden Teil (90) zu unterbrechen.

2. Eine Vorrichtung gemäß Anspruch 1, die ein unteres Plattenmittel zur Aufnahme einer Leiterplatte und ein oberes Plattenmittel zur Bereitstellung eines nach unten gerichteten Drucks auf die Komponente umfaßt.

3. Eine Vorrichtung gemäß Anspruch 2, bei der das untere Plattenmittel ein erstes Ausrichtungsmittel zur Ausrichtung der Leiterplatte in bezug auf das untere Plattenmittel und ein Mittel zur Halterung der Leiterplatte während der Druckanwendung umfaßt.

4. Eine Vorrichtung gemäß Anspruch 3, bei der das obere Plattenmittel ein zweites Ausrichtungsmittel zur Bereitstellung einer vertikalen Ausrichtung des oberen Plattenmittels mit dem unteren Plattenmittel sowie ein Federmittel zur Gewährleistung einer gleichmäßigen Druckanwendung auf die Komponente umfaßt.

5. Eine Vorrichtung gemäß Anspruch 2, 3 oder 4, bei der das Druckanwendungsmittel so ausgelegt ist, daß zwischen dem oberen Plattenmittel und dem unteren Plattenmittel ein Druck angelegt werden kann.

6. Ein Verfahren für das Andrücken mindesten einer elektrischen Komponente auf eine Leiterplatte, wobei die Komponente mit einer Mehrzahl elektrisch leitender Stifte ausgestattet ist, die in entsprechende Löcher auf der Leiterplatte eingesteckt werden, bestehend aus den Schritten des Ausübens eines gleichmäßigen Drucks auf die Komponente in im wesentlichen vertikaler Richtung, und der Überprüfung des richtigen Sitzes der Komponente auf der Leiterplatte, wobei der Schritt der Überprüfung die Bereitstellung eines elektrisch leitenden Pfads zwischen einem Anzeigemittel und einer elektrischen Stromquelle unter Verwendung eines Schaltkreismittels umfaßt, wenn ein Stift im ensprechenden Loch fehlt, wobei das Schaltkreismittel einen elektrischen Testfühler (98) für jeden der Stifte umfaßt, die innerhalb eines elektrischen Isolationsgehäuseteils (86) angeordnet sind, und einen elektrisch leitenden Endteil (96) und ein elektrisches Kontaktmittel (108) besitzen und an einem Ende des Testfühlers gegenüber dem Endteil angebracht sind und in Kontakt liegen mit einer ringförmigen Schulter (90), die sich in einem Loch (113) in einer elektrisch leitenden Schicht (84) zwischen dem Fühler und einer Leiterplattenposition befindet, wobei die ringförmige Schulter (90) einen kleineren Durchmesser aufweist als das Kontaktmittel (108), wobei jeder Fühler (98) ausrichtbar ist mit einem Loch auf der Seite der Leiterplattenposition gegenüber der Komponente, wobei das elektrische Kontaktmittel (108) von einem Stift (46), der durch die Öffnung (50) in ein Loch (113) ragt, nach unten gedrückt werden kann, um den Kontakt mit der ringförmigen Schulter (90) zu unterbrechen.

7. Ein Verfahren gemäß Anspruch 6, bei dem ein Druck nach unten auf die Komponente ausgeübt wird.

## Revendications

1. Dispositif permettant d'introduire au moins un composant électrique (42) sur une carte (40), le composant électrique (42) comprenant un ensemble de broches conductrices de l'électricité (46) à introduire dans des trous correspondants (50) de la carte (40), le dispositif comprenant des moyens (80) permettant d'appliquer une pression uniforme au composant selon une direction essentiellement verticale, caractérisé en ce que le dispositif comprend des moyens (82) pour vérifier la mise en position adéquate du composant (42) sur la carte (40), les moyens de vérification (82) comprenant des moyens fournissant une indication d'une absence de broche dans le trou correspondant, les moyens d'indication comprenant une source d'énergie électrique et des circuits pour fournir un chemin électriquement conducteur comprenant la source d'alimentation électrique, lorsque la broche est absente du trou correspondant, le circuit comprenant une sonde de test électrique (98) pour chaque broche, disposée dans une partie (86) électriquement isolante, et ayant une partie terminale électriquement conductrice (96) et des moyens de contact électrique (108) disposés en une extrémité de la sonde de test opposée à la partie terminale et mise en contact avec une gorge (90) disposée dans un trou (113) d'une couche électriquement conductrice (84) placée entre la sonde et une partie de la carte, la gorge (90) ayant un diamètre inférieur aux moyens de contact (108), chaque sonde (98) étant alignable avec un trou sur l'une des faces de la carte située à l'opposé du composant, les moyens de contact électrique (108) pouvant être enfoncés par une broche (46) s'étendant à travers un trou (50) et dans le trou (113), pour rompre le contact avec la gorge (90).

2. Dispositif selon la revendication 1 comprenant une plaque de base pour recevoir la carte, et une plaque supérieure pour appliquer une pression vers le bas sur le composant.

3. Dispositif selon la revendication 2, dans lequel la plaque de base contient des premiers moyens d'alignement pour aligner la carte par rapport à la plaque de base, et des moyens pour supporter la carte durant l'application de la pression.

4. Dispositif selon la revendication 3, dans lequel la plaque supérieure comprend des seconds moyens d'alignement pour aligner verticalement la plaque supérieure par rapport à la plaque de base, et des moyens à ressort pour assurer l'application d'une pression uniforme sur le composant.

5. Dispositif selon la revendication 2, 3 ou 4 dans lequel les moyens d'application de pression sont disposés pour appliquer une pression entre la plaque supérieure et la plaque de base.

6. Méthode d'introduction d'au moins un composant électrique sur une carte, le composant comprenant un ensemble de broches électriquement conductrices à introduire dans des trous correspondants de la carte, comprenant les étapes d'application d'une pression uniforme sur le composant selon une direction pratiquement verticale, et vérification du placement correct du composant sur la carte, l'étape de vérification comprenant la réalisation, à l'aide d'un circuit, d'un trajet électriquement conducteur entre un moyen indicateur et une source d'énergie électrique indiquant l'absence d'une broche dans le trou correspondant, le circuit comprenant une sonde de test (98) pour chaque broche, disposée dans une partie électriquement isolante (86), et ayant une partie terminale électriquement conductrice (96) et des moyens de contact électrique (108) disposés à l'une des extrémités de la sonde de test à l'opposé de la partie terminale et forcés en contact avec une gorge (90) disposée dans un trou (113) d'une couche électriquement conductrice (84) placée entre la sonde et une position de la carte, la gorge (90) ayant un diamètre inférieur à celui du moyen de contact (108), chaque sonde (98) étant alignée avec un trou sur une des faces de la carte à l'opposé du composant, le moyen de contact électrique (108) pouvant être enfoncé par une broche (46) s'étendant à travers un trou (50) et traversant le trou (113) pour rompre le contact avec la gorge (90).

7. Méthode selon la revendication 6, dans laquelle la pression est appliquée de haut en bas sur le composant.
